Europäisches Patentamt

European Patent Office

Office européen des brevets

(19)

(11) Veröffentlichungsnummer: **0 002 486**
**B1**

(12)            **EUROPÄISCHE PATENTSCHRIFT**

(45) Veröffentlichungstag der Patentschrift: **16.09.81**

(21) Anmeldenummer: **78101565.6**

(22) Anmeldetag: **05.12.78**

(51) Int. Cl.³: **H 01 L 29/62,**
**G 11 C 11/40,**
**H 01 L 27/10, H 03 K 3/353**

(54) Statische Speicherzelle aus zwei Feldeffekttransistoren und Verwendung derselben in einem programmierfähigen logischen Schaltungsverband.

(30) Priorität: **20.12.77 US 862476**

(43) Veröffentlichungstag der Anmeldung:
**27.06.79 Patentblatt 79/13**

(45) Bekanntmachung des Hinweises auf die Patenterteilung:
**16.09.81 Patentblatt 81/37**

(84) Benannte Vertragsstaaten:
**DE FR GB**

(56) Entgegenhaltungen:
**FR - A - 2 203 173**

**IEEE JOURNAL OF SOLID STATE CIRCUITS,
Vol. sc—12, Nr. 5, Oktober 1977,,
New York, USA,
T. R. O'CONNELL et al. "Two static 4K clocked
and nonclocked RAM designs", Seiten 497—501**

(73) Patentinhaber: **International Business Machines
Corporation
Armonk, N.Y. 10504 (US)**

(72) Erfinder: **Bertin, Claude Louis
10501 Adel Road
Oakton Virginia 22124 (US)**

(74) Vertreter: **Rudolph, Wolfgang
Schönaicher Strasse 220
D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Statische Speicherzelle aus zwei Feldeffekttransistoren und Verwendung derselben in einem programmierfähigen logischen Schaltungsverband

Die Erfindung betrifft eine statische Speicherzelle aus zwei Feldeffekttransistoren, deren Elektroden untereinander und/oder mit Ansteuer-, Ein- und Ausgangsleitungen in einem Speicherzellenverband oder in einer Anordnung aus vielen steuerbaren, logischen Schaltungen in Verbindung stehen, bei der der erste Feldeffekttransistor mit seiner Source-Elektrode am Erdpotential und mit seiner Drain-Elektrode an einem ersten Ausgangsknotenpunkt angeschlossen ist, der über einen ersten Lastwiderstand mit einem beiden Feldeffekttransistoren gemeinsamen Drain-Potential verbunden ist, und bie der der zweite Feldeffekttransistor mit seiner Source-Elektrode am Erdpotential und mit seiner Drain-Elektrode an einem zweiten Ausgangsknotenpunkt angeschlossen ist, der über einen zweiten Lastwiderstand mit dem Drain-Potential verbunden ist.

Ferner betrifft die Erfindung die Verwendung einer derartigen statischen Speicherzelle in einem programmierfähigen logischen Schaltungsverband.

Außerdem ist aus der DE—OS 24 31 079 ein Speicher mit tatsächlich nur zwei Feldeffekttransistoren pro Speicherzelle bekannt geworden, der jedoch die zu speichernde Information nicht halten kann. Aus diesem Grund wird er dynamisch betrieben, d.h., der jeweilige Zustand der Speicherzelle wird laufend generiert. Obwohl sich eine derartig aufgebaute dynamische Speicherzelle mit Feldeffekttransistoren durch einen sehr kleinen Platzbedarf innerhalb eines Speicherverbands auszeichnet, hat eine dynamisch betriebene Speicherzelle den Nachteil, daß sie bedingt durch die unbedingt erforderlichen Regenerationszyklen relativ langsam ist.

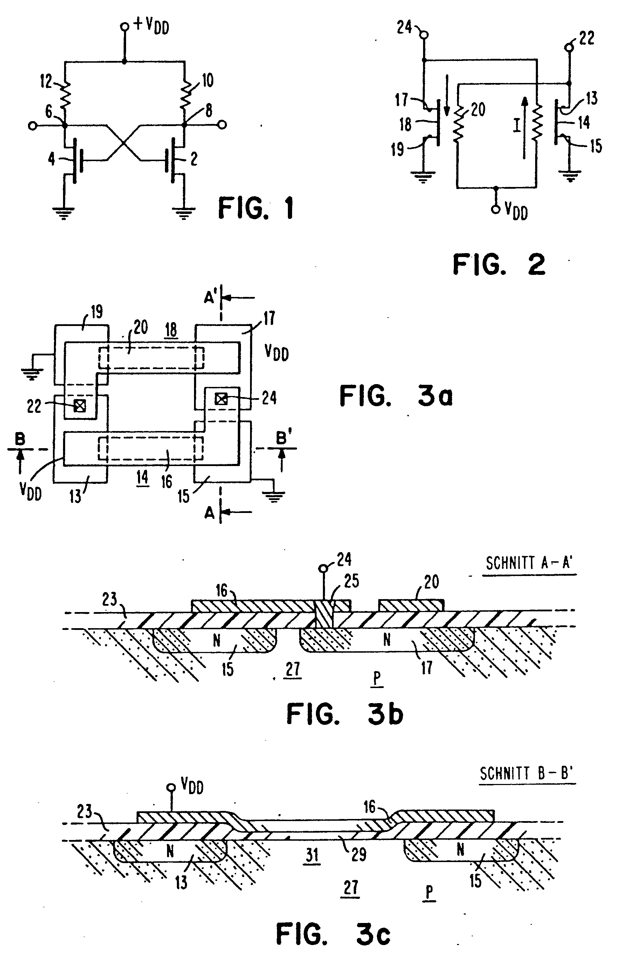

Fig. 1 zeigt eine solche herkömmliche Flipflopschaltung z.B. nach US—PS 40 25 940 mit den aktiven FET 2 und FET 4, deren Gates überkreuz mit den Knotenpunkten 6 und 8 gekoppelt sind, und diese sind wiederum über Ladeelemente 10 und 12 mit dem Drainpotential VDD verbunden. Der FET 2 wird durch ein positives Potential am Knotenpunkt 6 eingeschaltet und öffnet den Stromweg über die resistive Last 10 zwischen VDD und Erde, so daß das Potential am Knotenpunkt 8 abfällt. Da der Knotenpunkt 8 mit dem Gate des FET 4 verbunden ist, wird dieser abgeschaltet, stoppt den Stromfluß durch die Last 12 und läßt dadurch das Potential am Knotenpunkt 6 ansteigen. Dieser Potentialanstieg am Knotenpunkt 6, der auf das Gate des FET 2 übertragen wird, hält den FET 2 eingeschaltet und macht diesen Schaltzustand dadurch stabil. Der Schaltzustand der Flipflop-Schaltung in Fig. 1 wird dadurch umgekehrt, daß man ein Einschaltsignal an den Knotenpunkt 8 anlegt und so den FET 4 einschaltet. Dadurch steigt der Stromfluß durch die Last 12 an und das Potential am Knotenpunkt 6 wird reduziert. Dadurch wiederum wird auch das Potential am Gate des FET 2 reduziert und dieser abgeschaltet. Wenn der FET 2 abgeschaltet ist, wird der Stromfluß durch die Last 10 gestoppt und das Potential am Knotenpunkt 8 steigt an, so daß das Gate des FET 4 den FET leitend schaltet und so diesen Einschaltzustand hält, so daß die Flipflop-Schaltung der Fig. 1 in diesem zweiten stabilen Zustand verbleibt.

Bisher wurden vielerlei Lasten 10 und 12 verwendet, wie beispielsweise einfach diffundierte Widerstände FETs vom Verarmungs- oder Anreicherungstyp sowie Schichten aus einem polykristallinen Silicium auf der Passivierungsschicht für die integrierte Schaltung. Da bistabile Schaltungen der in Fig. 1 gezeigten Art in großen Mengen für die Speicherung von Informationen benutzt werden, ist die von der Schaltung von dem hochgradig integrierten Chip belegte Fläche in starkem Maße ausschlaggebend für die erreichbare Informationsspeicherdichte. Jede effektive Reduzierung bei der Packungsdichte von Flipflop-Schaltungen bringt einen direkten wirtschaftlichen Vorteil in Form der auf einem hochgradig integrierten Chip für eine bestimmte Anwendung speicherbaren Informationsmenge.

Aus IEEE Journal of Solid-State Circuits, Vol. SC—12, Nr. 5, Oktober 1977, Seiten 497 bis 511 ist eine statische Speicherzelle gemäß dem ersten Teil des Anspruchs 1 bekannt. Bei dieser Speicher zelle ist der erste Feldeffekttransistor mit seiner Source-Elektrode am Erdpotential und mit seiner Drain-Elektrode an einem ersten Ausgangsknotenpunkt angeschlossen; der zweite Feldeffekttransistor ist mit seiner Source-Elektrode am Erdpotential und mit seiner Drain-Elektrode an einem zweiten Ausgangsknotenpunkt angeschlossen; der erste Ausgangsknotenpunkt ist über einen Widerstand mit einem Potential der Drain-Elektrode verbunden und der zweite Ausgangsknotenpunkt ist über einen Widerstand mit einem Potential der Drain-Elektrode der ersten Feldeffekttransistors verbunden. Diese Speicherzelle weist zwar bereits einen sehr hohen Integrationsgrad auf, ist jedoch für eine weitere Erhöhung der Schaltungspackungsdichte für statisch betriebene Speicherschaltungen mit zwei Feldeffekttransistoren in hochgradig integrierten Chips ungeeignet.

Die Aufgabe der Erfindung besteht daher in der Erhöhung der Schaltungspackungsdichte für statisch betriebene Speicherschaltungen mit zwei Feldeffekttransistoren in hochgradig integrierten Chips und in der Reduzierung der Anzahl von Schaltelementen für in einem Halbleiterspeicher verwendete Speicherschaltungen.

Die Aufgabe der Erfindung wird durch eine eingangs genannte statische Speicherzelle aus zwei Feldeffekttransistoren gelöst, die dadurch charakterisiert ist, daß der erste Lastwiderstand eine als Widerstand ausgebildete Gate-Elektrode des· zweiten Feldeffekttransistors und der zweite Lastwiderstand eine als Widerstand ausgebildete Gate-Elektrode des ersten Feldeffekttransistors ist.

Eine als Widerstand ausgebildete Gate-Elektrode wird im folgenden als Widerstandsgate bezeichnet.

Besondere Ausführungsarten der Erfindung sind in den Patentansprüchen 2 bis 9 detailliert dargelegt.

Weiterhin besteht die Erfindung in der Verwendung einer erfindungsgemäßen statischen Speicherzelle in einem programmierfähigen logischen Schaltungsverband, wobei die Speicherzelle in dem Schaltungsverband als Programmierelement für einen im UND-Bereich geschalteten Personalisierungstransistor sowie als Programmierelement für einen im ODER-Bereich geschalteten Personalisierungstransistor verwendet wird.

Ausführungsbeispiele der Erfindung sind in den beigefügten Zeichnungen dargestellt und werden anschließend näher beschrieben.

Es zeigen:

Fig. 1 schematisch eine herkömmliche Flipflop-Schaltung aus FETs,

Fig. 2 schematisch eine Flipflop-Schaltung mit FETs mit Widerstandsgate,

Fig. 3a eine Halbleiterstruktur der Flipflop-Schaltung mit Feldeffekttransistoren mit Widerstandsgate,

Fig. 3b eine Schnittansicht der in Fig. 3a gezeigten Schaltung,

Fig. 4a das Schaltbild eines UND-FETs in einer programmierbaren logischen Anordnung (PLA),

Fig. 4b ein Schaltbild eines UND-FETs in einer programmierbaren logischen Anordnung (PLA),

Fig. 4c eine Draufsicht auf einen elektrisch programmierbaren Speicher, in dem eine Flipflop-Schaltung aus Feldeffekttransistoren mit Widerstandsgate verwendet wird,

Fig. 5a eine Draufsicht auf eine Flipflop-Schaltung, die Feldeffekttransistoren mit Widerstandsgate benutzt, worin die Diffusionen durch Ionen-implantation nach dem Niederschlag der polykristallinen Silicium-Gatebereiche gebildet werden,

Fig. 5b eine Schnittansicht entlang der Linie A—A' in Fig. 5a,

Fig. 5c eine Schnittansicht entlang der Linie B—B' in Fig. 5a,

Fig. 6 eine Draufsicht auf eine Flipflop-Schaltung, die Feldeffekttransistoren mit Widerstandsgate verwendet und in einem Randomspeicher angewandt wird,

Fig. 7 schematisch die Verbindung der Elemente für die in Fig. 6 gezeigte Randomspeicherzelle und

Fig. 8 eine Draufsicht für eine andere bistabile Kippschaltung mit Feldeffekttransistoren mit Widerstandsgate, wie sie in einem elektrisch programmierbaren Speicher verwendet wird.

Die Fig. 2 zeigt die Flipflop-Schaltung, die Feldeffekttransistoren mit resistivem Gate verwendet. Der Feldeffekttransistor 14 ist mit seiner Source 15 an Erdpotential und mit seiner Drain 13 an einen ersten Ausgangsknotenpunkt 22 angeschlossen. Der Feldeffekttransistor 18 ist mit seiner Source 19 an Erdpotential und mit seiner Drain 17 an den zweiten Ausgangsknoten 24 angeschlossen. Der erste Ausgangsknoten 22 für den ersten FET 14 ist über das als Widerstand ausgebildete Gate, nachfolgend Widerstandsgate 20 genannt, des zweiten FETs 18 mit dem Drainpotential VDD verbunden. Entsprechend ist der zweite Ausgangsknoten 24 über das Widerstandsgate 16 für den ersten FET 14 mit dem Drainpotential VDD verbunden. Der Leitzustand der beiden FETs 14 und 18 ist daher von der Menge des durch das gegenüberliegende Element fließenden Stromes abhängig. Dadurch erhält man die für den Betrieb einer statischen Flipflop-Schaltung notwendige Kreuzkopplungswirkung.

Fig. 3a zeigt in einer Draufsicht die Anlage der schematisch in Fig. 2 dargestellten Schaltung, wobei die gleichen Bezugszeichen dieselben Elemente bezeichnen. Der FET 14 enthält die mit Erde verbundene Source-Diffusion 15 und die mit dem ersten Ausgangsknoten 22 verbundene Drain-Diffusion 13. Das Widerstandsgate 16 liegt über dem Kanalbereich, trennt die Source- und Drain-Diffusionen voneinander und besteht aus polykristallinem Silicium mit einem hohen Widerstandswert. Das Ende des Widerstandsgate 16 liegt über der Drain-Diffusion 13 und ist nicht damit, sondern stattdessen mit dem Drainpotential VDD. Entsprechend wird der FET 18 gebildet durch die Source-Diffusion 19, die mit Erdpotential verbunden ist, und die Drain-Diffusion 17, die an den zweiten Ausgangsknoten 24 angeschlossen ist. Das Widerstandsgate 20 ist mit einem Ende an den Ausgangsknotenpunkt 22 und mit dem anderen an das VDD-Potential gelegt, mit der darunterliegenden Drain-Diffusion 17 besteht jedoch keine Verbindung. Der Kanalbereich des ersten FETs 14 zwischen der Source-Diffusion 15 und der Drain-Diffusion 13 und unter dem Widerstandsgate 16 und der Kanalbereich des FETs 18 zwischen Source-Diffusion 19 und Drain-Diffusion 17 und unter dem Widerstandsgate 20 ist so mit Ionen implantiert, daß die Schwellspannung VT ungefähr 1/3 bis 1/2 des Wertes von VDD ist. Der Widerstandswert des polykristallinen Siliciummaterials, das für die Widerstandsgates 16 und 20 verwendet wird. liegt über 100 kOhm pro Quadrat.

Fig. 2 zeigt den Strom, der durch das Widerstandsgate 16 des FETs 14 und weiter von der Drain-Diffusion 17 zur Source-Diffusion 19 des zweiten FETs 18 fließt. Der Widerstandswert des Widerstandsgates 16 für den ersten FET 14 ist wesentlich größer als der Widerstand im Kanalbereich für den zweiten FET 18, so daß die Ausgangsspannung am zweiten Ausgangsknoten 24 in der Nähe des Erdpotentials liegt und somit eine binäre Null darstellt. Da die Schwellspannung für beide FETs ungefähr 1/3 bis 1/2 der Größe des Drain-Potentials VDD erreicht, wird nur etwa 1/3 bis die Hälfte der Kanallänge für den ersten FET 14 invertiert und leitet daher nicht. Die Ausgangsspannung am ersten Ausgangsknoten 22 ist somit ungefähr so groß wie VDD, da durch das Widerstandsgate 20 des zweiten FETs 18 kein Strom fließt. Das Gate-Potential des zweiten FET 18 ist über dem ganzen Gatebereich gleich VDD, so daß der FET 18 eingeschaltet gehalten wird. Die bistabile Kippschalterwirkung wird durch die in Fig. 2 gezeigte Schaltung erreicht und dabei werden weniger Schaltelemente verwendet und eine kleinere Schaltfläche gebraucht als bei herkömmlichen statischen bistabilen Kippschaltungen.

Fig. 3a zeigt die Struktur der in Fig. 2 dargestellten Schaltung. Das Breiten-Längenverhältnis des Gates, die Oxidausschnitte, die Länge der Elemente, die Oxiddotierung oder Polysiliciumdotierungen können verschieden voneinander gestaltet werden, um so einen asymmetrischen Zustand zu erreichen, in dem das Flipflop immer in einen Schaltzustand übergeht, sobald VDD von Null hochgebracht wird.

Fig. 3b zeigt eine Schnittansicht der in Fig. 3a dargestellten Struktur entlang der Linie A—A'. Die N-leitenden Source- und Drain-Diffusionen 15 und 17 werden in ein aus Silicium zusammgesetztes P-leitendes Substrat 27 diffundiert, oder Ionen implantiert. Eine Siliciumdioxidschicht 23 bedeckt die Oberfläche des Siliciumsubstrates 27 und auf dieser Siliciumdioxidschicht werden die polykristallinen Schichten für das Widerstandsgate 16 und das Widerstandsgate 20 niedergeschlagen. Ein Durchgangsloch 25 verbindet das Gate 16 mit der Drain-Diffusion 17 und dient als zweiter Ausgangsknoten 24.

Fig. 3c zeigt in einer Schnittansicht entlang der Linie B—B der in Fig. 3A dargestellten Struktur den FET im einzelnen. Die N-leitenden Source- und Drain-Diffusionen 13 und 15 werden in das P-leitende Siliciumsubstrat 27 diffundiert oder Ionen implantiert. Darüber wird eine dicke Schicht aus Siliciumdioxid 23 niedergeschlagen und ein dünner Bereich aus Siliciumdioxid 29 bildet das Gate-Oxid für den FET. Über den Oxidschichten 23 und 29 wird das Widerstandsgate 16 aus polykristallinem Silicium niedergeschlagen, an dessen über der Drain-Diffusion 13 liegendes Ende das Drain-Potential VDD angelegt wird. Der Kanalbereich 31 für den FET liegt zwischen der Drain-Diffusion 13 und der Source-Diffusion 15.

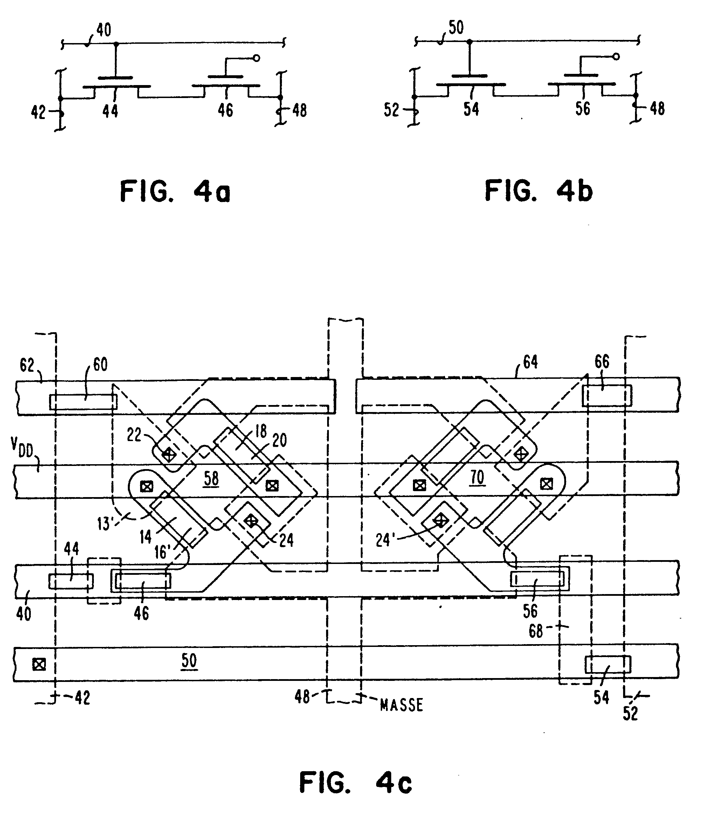

Die Fign. 4a, 4b und 4c zeigen die Anwendung von bistabilen FETs mit Widerstandsgate in einem programmierbaren PLA. Das PLA ist insgesamt nach dem gemischten Konzept angelegt, das an anderer Stelle im einzelnen beschrieben ist (US Patent 4 140 967). Die in Fig. 3a gezeigte bistabile Kippschaltung kann in einem gemischten Speicherbereich des PLA als Schaltung eingeführt werden, die eine vorgegebene Personalisierung speichert und deren Ausgang mit dem Gate eines FETs mit UND-Bereichen und ODER-Bereichen in Reihe geschaltet ist. In dem Schaltschema der Fig. 4A ist die Bitteilerleitung 40 mit dem Gate eines im UND-Bereich verbundenen Transistors 44 und die Produktterm-Diffusionsleitung 42 mit der Source desselben Transistors verbunden. Die Drain des Transistors 44 ist mit der Source eines im UND-Bereich geschalteten Personalisierungstransistors 46 verbunden, dessen Drain an die Erdleitung 48 angeschlossen ist. Das Gate des Personalisierungstransistors 46 ist mit der Flipflop-Schaltung verbunden, die den Personalisierungszustand für den Personalisierungstransistor 46 einstellt.

In Fig. 4b ist die Produkttermleitung 50 mit dem Gate des im ODER-Bereich geschalteten Transistors 54 und die Ausgangsdiffusionsleitung 52 mit der Source dieses Transistors verbunden. Die Drain des Transistors 54 ist mit der Source des im ODER-Bereich geschalteten Personalisierungstransistors 56 verbunden, dessen Drain an die Erdleitung 48 angeschlossen ist. Das Gate des Personalisierungstransistors 56 ist mit einer bistabilen Kippschaltung verbunden, die den Personalisierungszustand des Personalisierungstransistors 56 elektrisch einstellt.

Fig. 4c zeigt eine Draufsicht auf einen elektrisch programmierbaren PLA, wo die Flipflop-Schaltung aus FETs mit resistivem Gate als Programmierelement 58 für den im UND-Bereich geschalteten Personalisierungstransistor 46 und als Programmierelement 70 für den im ODER-Bereich geschalteten Personalisierungstransistor 56 verwendet wird. Die Schaltstellung des Flipflop 58 wird über ein Signal auf der Flipflop-Einstell-leitung 62 eingestellt, die selektiv den ersten Ausgangsknoten 22 über den im UND-Bereich geschalteten Einstelltransistor 60 mit der Produktterm-Diffusionsleitung 42 verbindet. Diese kann mit einer Spannung gepulst werden, die ausreicht, um das Flipflop 58 in den gewünschten Zustand zu schalten. Die Widerstandsgateelektrode 16', die mit dem zweiten Ausgangsknoten 24 verbunden ist, hat eine Verlängerung, die als Gate für den im UND-Bereich geschalteten Personalisierungstransistor 56 dient, so daß das Gate für den Transistor 56 in wesentlichen dieselbe Spannung hat wie der Ausgangsknotenpunkt 24, wenn dieser eine Einschaltspannung hat. Dadurch wird der Personalisierungstransistor und hierdurch wiederum der in dem UND-Bereich geschaltete Transistor 44 eingeschaltet. Wenn das Flipflop 58 über die Flipflop-Einstell-leitung 62 ausgeschaltet wird, so daß der Ausgangsknoten 24 die Ausschaltspannung hat, dann ist auch der Personalisierungstransistor 46 und damit der Transistor 44 abgeschaltet.

Entsprechend schaltet ein Signal auf der Flipflop-Einstell-leitung 64 das Flipflop 70 über den im ODER-Bereich geschalteten Einstelltransistor 66 in den Zustand, der durch den an die Ausgangsdiffusionsleitung 52 angelegten Spannungsimpuls bestimmt wird. Der Zustand des Ausgangsknotenpunktes 24' für das Flipflop 70 wird als Gatepotential an den im ODER-Bereich geschalteten Personalisierungstransistor 56 angelegt, und dadurch der Transistor 54 ein- oder ausgeschaltet. Die Leitungen 40, 50, 62, 64 und $V_{DD}$ sind Metalleitungen in einer Ebene, die über der von den Widerstandsgateelektroden 16' und 20' belegten Ebene liegt, und diese liegt wiederum über der Ebene, in der die Produkttermleitung 42, die Erdleitung 48 und die Ausgangsleitung 52 diffundiert sind. Die FETs 44 und 54 sind also FETs mit Metallgate, während die FETs 46 und 56 ein Siliciumgate haben.

Es können also die FETs 44 bzw. 54 elektronisch programmiert und wiederholt geändert werden, wobei diese Änderung mit elektronischer Geschwindigkeit erfolgt. Die PLA-Schaltung ist gekennzeichnet durch ein sehr kleines wirksames Flipflop, das das Konzept des FET-Flipflop mit Widerstandsgate benutzt. Mit dieser Grundzelle gebaute PLA-hochintegrierte-Chips werden nützlich überall dort eingesetzt, wo zahlreiche technische Änderungen im Produkt angenommen werden. Das Element fand auch nützliche Anwendung als Maschinenmodellwerkzeug für die Maschinenentwicklung.

Die Fign. 5a bis 5c zeigen ein anderes Ausführungsbeispiel der Struktur für das FET-Flipflop mit Widerstandsgate, dessen elektrisches Schema in Fig. 2 gezeigt ist. Gleiche Bezugszeichen entsprechen gleichen Teilen in Fig. 2 und den Fign. 5a bis 5c.

In Fig. 5a ist eine Draufsicht der Struktur des Flipflop gezeigt, das Feldeffekttransistoren mit Widerstandsgate verwendert, wo die Diffusionen durch einen Ionenimplantation nach dem Niederschlag der polykristallinen Siliciumgatebereiche gebildet werden. Die in den Fign. 5a bis 5c gezeigte Struktur hat den Vorteil, daß sie noch kompakter und leichter herzustellen ist als die in Fig. 3a gezeigte Anordnung.

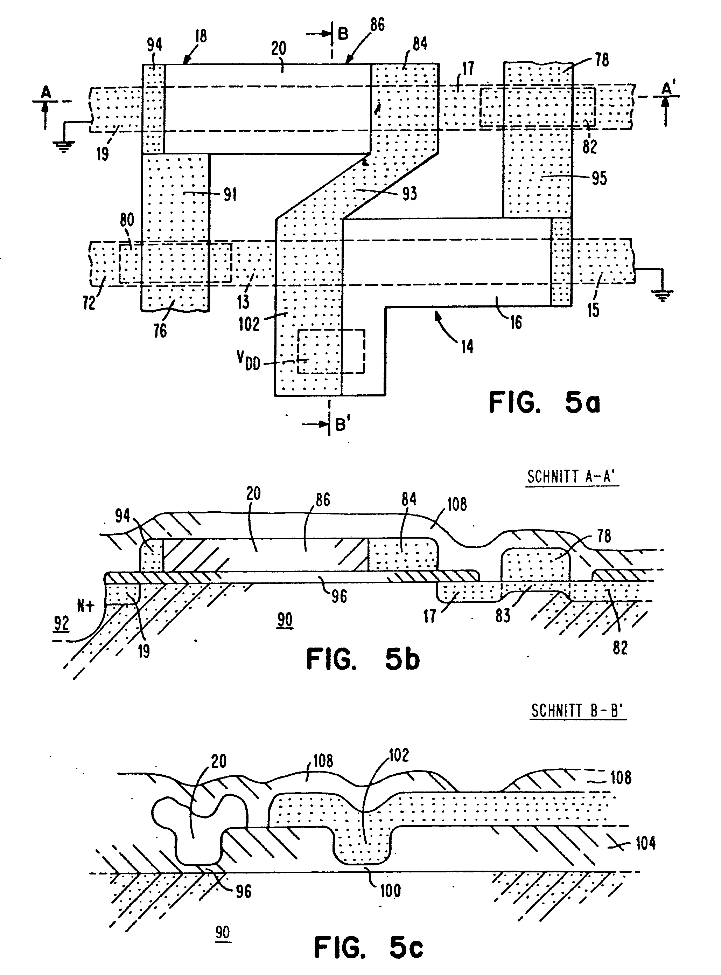

Fig. 5a zeigt eine Draufsicht, in der die beiden FETs 14 und 18 so gebildet werden, daß ihre Gateteile 16 und 20 ein zusammenhängendes Stück polykristallinen Siliciums bilden, das dotiert ist, um seine Leitfähigkeit zu erhöhen. Die strukturellen Verbesserungen sind aus Fig. 5b und 5c zu ersehen, die einer Querschnitt entlang der Linie A—A' zeigt. Aus Fig. 5b ist zu sehen, daß im wesentlichen über der ganzen Oberfläche des Siliciumsubstrates 90 eine dicke Schicht des Feldoxids 104 aufgewachsen ist. In einem nachfolgenden Ätzschritt wird das Feldoxid in dem Bereich entfernt, in dem das FET-Flipflop mit dem Widerstandsgate liegen soll. Eine dünne Oxidschicht 96 wird dann auf der freigelegten Oberfläche des Siliciumsubstrates 90 aufgewachsen. Danach werden die Bereiche 80 und 82 durch die dünne Oxidschicht 96 hindurchgeätzt, damit hinterher die Kontaktbereiche 76 und 78 zum Substrat ausgebildet werden können. Danach wird auf der Oberfläche eine polykristalline Siliciumschicht 86 ausgebildet und durch Photolithographie das in Fig. 5a gezeigte Muster ausgebildet, das den Kontaktbereich 102, das Gate 16 für den FET 14 und den Kontakt 78 und zusätzlich das Gate 20 für den FET 18 und den Kontakt 76 definiert.

Nachdem die in den Fign. 5a und 5b dargestellte Struktur auf der polykristallinen Siliciumschicht ausgebildet ist, werden durch Ionenimplantation die Bereiche 16 und 20, die einen hohen Widerstandswert haben, für die FETs 14 und 18 und die Verbindungteile 91, 93 und 95 mit niedrigem Widerstand definiert. Im Ausführungsbeispiel ist das Siliciumsubstrat 90 P-leitend dotiert und hat einen Widerstandswert von 2 Ohm-cm. Das dünne Oxid 96 ist zwischen 50 und 70 nm (500 und 700 Å) dick, die Polysiliciumschicht 86 ungefähr 2 $\mu$. Die Ionenimplantation wird mit N-Dotierung wie Phosphor bei einer Beschleunigungsenergie zwischen 75 keV und einer Dosierung von ungefähr $10^{15}$ Atomen/$cm^2$ ausgeführt. Durch die Ionenimplantation wird nicht nur die Leitfähigkeit der polykristallinen Siliciumschichten 91, 93 und 95 selektiv erhöht, sondern es werden auch die Drain-Diffusion 13, die Source-Diffusion 15 für den FET 14 und die Drain-Diffusion 17 sowie die Source-Diffusion 19 für den FET 18 eingeführt. Die ionenimplantierten Diffusionen 19 und 15 stellen die Verbindung zu der Schaltungs-Erddiffusion 92 auf dem Chip her. Nach der Ionenimplantation wird die ganze Struktur thermisch bei ungefähr 900 bis 1000°C in einer Dampfatmosphäre oxidiert, um die Oxidschicht 108 aufzuwachsen und die ionenimplantierten Phosphoratome in den Kontaktbereichen 78 und 76 in den Teil 83 des Substrates 90 direkt unter den Strukturen auszudiffundieren. Der Kontakt 106 verbindet die Polysiliciumschicht 86 mit VDD.

Aus Fig. 5c ist die Beziehung zwischen den dünnen Oxidbereichen 96 und 100 für die FETs 18 bzw. 14 besser zu sehen. Fig. 5c ist eine Schnittansicht entlang der Linie B—B' in Fig. 5a.

Aus den Fign. 5a bis 5c ist zu sehen, daß sich diese Struktur durch die gleichzeitige Ausbildung der Leiterteile 94 und 84 beispielsweise in der Polysiliciumschicht, der diffundierten Bereiche 72 und 82, beispielsweise im Halbleitersubstrat 90, des Leiterteiles der Kontakte 78 und 76 und der Verbindung der Schaltung durch die ionenimplantierte Diffusion 19

zum Ausgleich des Erdnetzes durch die beschriebene Ionenimplantation und den anschließenden Erwärmungszyklus leichter herstellen läßt. Die ganze Struktur ist außerdem kompakter ausgelegt als die in Fig. 3a gezeigte Struktur wegen der Selbstausrichtung, worin die Drain-Diffusion 17 und die Source-Diffusion 19 für den FET 18 auf die Kante, beispielsweise des Gatebereiches 20, ausgerichtet sind. Dadurch werden die photolithographischen Toleranzen reduziert, die zur Fabrikation mit mehreren Masken gehören.

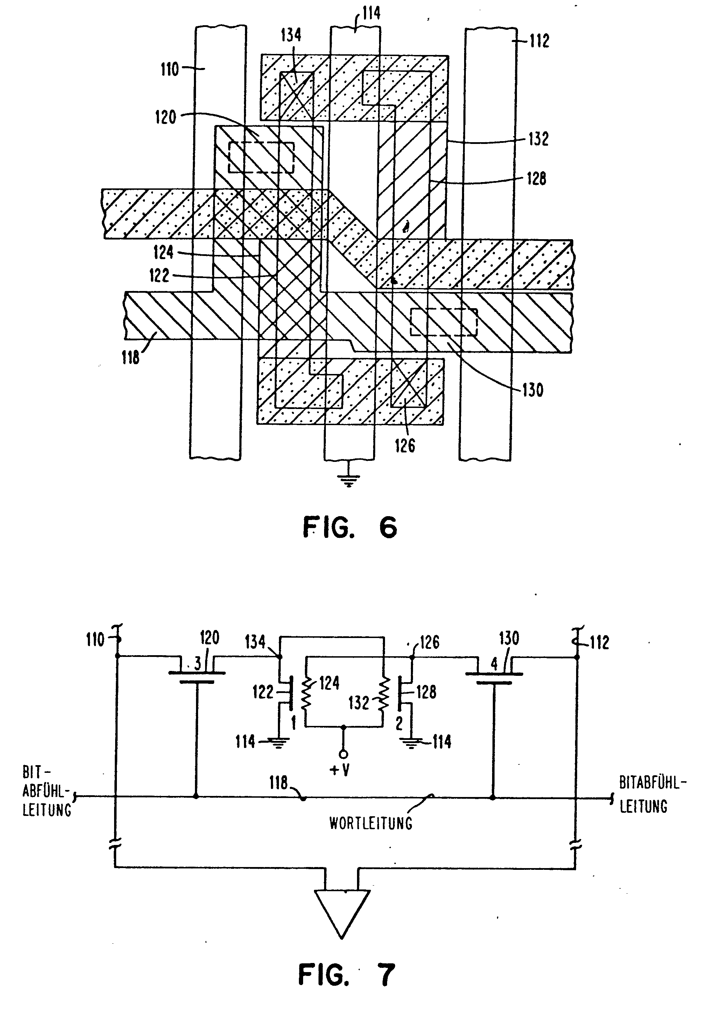

In Fig. 6 ist eine Randomspeicherzelle gezeigt, die die Grundanlage der polykristallinen Siliciumstruktur in Fig. 5a benutzt und sie auf die in Fig. 7 gezeigte Randomspeicherschaltung anwendet. Die numerierten Elemente in Fig. 6 entsprechen denen in Fig. 7.

Nach Darstellung in Fig. 7 ist der Randomspeicher in vertikale Spalten und horizontale Zeilen von Speicherzellen aufgeteilt. Jede Zelle besteht aus der schematisch in Fig. 2 gezeigten Flipflop-Schaltung, die in Fig. 7 noch einmal dargestellt ist und von den vertikalen Bitleitungen 110 und 112 durch Übertrager 120 und 130 getrennt ist, die durch ein Signal auf der horizontalen Wortleitung 118 eingeschaltet werden.

Die Flipflop-Schaltung der Fig. 2 steht in der nachfolgend aufgeführten Beziehung zur Flipflop-Schaltung der Fig. 7. Der FET 14 in Fig. 2 entspricht dem FET 128 und der FET 18 dem FET 122 in Fig. 7. Der Ausgangsknotenpunkt 22 in Fig. 2 entspricht dem Ausgangsknotenpunkt 126 und der Ausgangsknotenpunkt 24 dem Ausgangsknotenpunkt 134 in Fig. 7. Der Ausgangsknotenpunkt 126 in Fig. 7 ist mit der vertikalen Bitleitung 112 durch den Übertrager 130 und der Ausgangsknotenpunkt 134 mit der vertikalen Bitleitung 110 durch den Übertrager 120 verbunden.

Um im Betrieb ein Bit in die Flipflop-Zelle der Fig. 7 zu schreiben, wird die Wortleitung 118 gepulst, um die Übertrager 120 und 130 einzuschalten. Gleichzeitig wird die Spannung beispielsweise auf der Bitleitung 110 abgesenkt und auf der Bitleitung 112 angehoben, um so den FET 122 einzuschalten und über die für die Schaltung in Fig. 2 beschriebene Flipflop-Wirkung den FET 128 abzuschalten. Zu dieser Zeit wird die Spannung auf der Wortleitung 118 reduziert und dadurch die Übertrager 120 und 130 abgeschaltet und so wurde ein Informationsbit in die Flipflop-Speicherzelle geschrieben. Um den Informationsinhalt der Speicherzelle in Fig. 7 zu lesen, wird die Spannung auf der Wortleitung 118 angehoben, dadurch werden die Übertrager 120 und 130 eingeschaltet und die entsprechenden Ausgangsknotenpunkte 134 und 126 mit den vertikalen Bitleitungen 110 bzw. 112 verbunden. Die durch die Zelle auf den Bitleitungen erzeugten relativen Spannungen werden dann durch den Differentialabfrage-Verstärker abgefühlt.

Fig. 6 zeigt die Struktur der RAM-Zellen, die schematisch in Fig. 7 gezeigt sind. Die in den Fign. 5a bis 5c dargestellte Struktur wurde für die Anwendung auf den in Fig. 7 gezeigten Randomspeicher modifiziert, in dem zwei Übertragungs-FETs 120 und 130 hinzugefügt wurden und die Erddiffusion 114 in die Mitte gelegt wurde. Außerdem sind die Bitleitungen 110 und 112 parallel zur Erddiffusion 114 gelegt. Schließlich ist die Wortleitung als Metallschicht 118 über einer Oxidschicht niedergeschlagen. Somit gibt es drei Verbindungsebenen, nämlich die Diffusionsebene und das Substrat 90, die Polysiliciumebene, dargestellt durch die Polysiliciumschicht 86 und die Metallschicht für die Wortleitung 118.

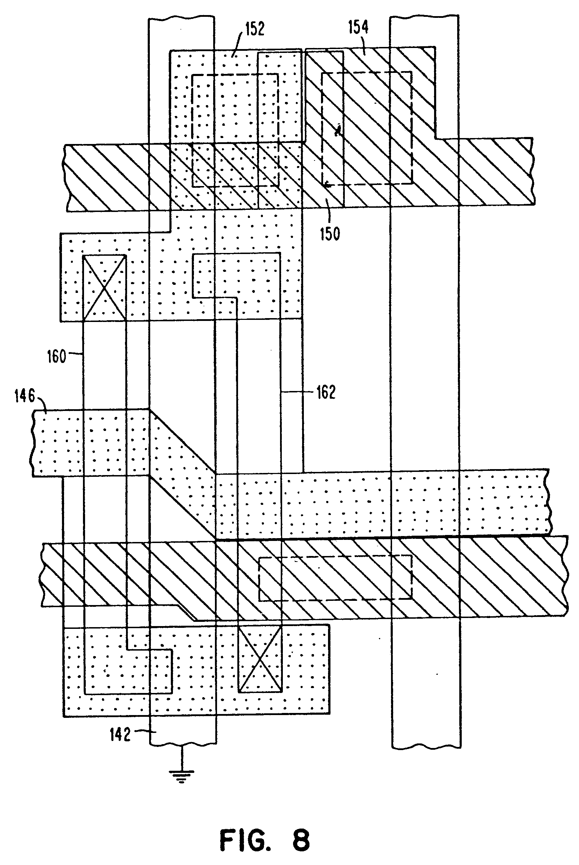

Eine weitere Anwendung derartiger Zellen ist der elektrisch programmierbare PLA, wie er in dem Schaltschema der Fig. 4a beschrieben wurde. Die in Fig. 8 gezeigte Flipflop-Schaltung hat die Aufgabe, den Leitfähigkeitsstatus des in Fig. 4a gezeigten Transistors 46 zu speichern, der dem in Fig. 8 gezeigten Element 152 entspricht. Der Produkttermtransistor 44 in Fig. 4a entspricht somit dem Transistor 154 in Fig. 8. Anlage und Struktur der Fign. 5a bis 5c wurde an die in Fig. 8 gezeigte Anwendung des elektronisch programmierbaren PLA angepaßt. Insbesondere sind der FET 14, dargestellt als FET 162 in Fig. 8, und der FET 18, dargestellt als FET 160 in Fig. 8 genauso gebaut wie die Elemente, die in Fig. 5a gezeigt sind. Der mit dem Gate des FETs 14 verbundene Ausgangsknotenpunkt 78 dient als Gate 152 für den Personalisierungstransistor 46, der wahlweise den in UND-Schaltung geschalteten Transistor 44 mit der Produktterm-Diffusionsleitung 42 verbindet. Wenn ein Impuls auf die Bitteilerleitung 40 ausgegeben wird, wird die Produktterm-Diffusionsleitung 42 mit der Erdleitung 48 über den Transistor 44 nur verbunden, wenn der Personalisierungstransistor 46 leitet, und dieser Leitzustand wird bestimmt durch den Speicherzustand, der aus den FETs 14 und 18 bestehenden Flipflop-Zelle.

Einige Vorteile der Flipflop-Zelle mit Widerstandsgate, wie sie in den Fign. 5a bis 5c gezeigt sind, für Anwendungen, wie die in den Fign. 6 und 7 gezeigte RAM-Zelle oder die elektrisch programmierbare PLA der Fig. 8 können wie folgt festgehalten werden. Der Hauptvorteil besteht darin, daß die FET-Struktur mit resistivem Gate zu bestehenden FET-Prozessen mit Metallgate hinzugefügt werden können. Wenn beispielsweise der herkömmliche Prozeß für FETs mit Metallgate durch den Source/Drain-Niederschlag und die erneute Oxidation abgeschlossen wird, dann werden für die Gate- und Kontaktbereiche für den Flipflop-Bereich Ausschnitte geöffnet, wie es im Zusammenhang mit den Fign. 5a bis 5c beschrieben wurde. Nachdem die Struktur entsprechend dieser Beschreibung gebildet wurde, kann der herkömmliche Prozeß für FETs mit Metallgate fortgesetzt werden. Dadurch wird ein elektrisch

programmierbares Speicherelement in Randomspeichern und PLA-Speichern mit Metallgate-Elementen eingebaut. Tatsächlich kann man in jeder logischen Schaltung, die FETs mit Metallgate oder polykristallinem Siliciumgate verwendet, Flipflop-Schaltungen mit Widerstandsgate anwenden.

**Patentansprüche**

1. Statische Speicherzelle aus zwei Feld-effekttransistoren, deren Elektroden un-tereinander und/oder mit Ansteuer-, Ein- und Ausgangsleitungen in einem Speicherzellenverband oder in einer Anordnung aus vielen steuerbaren, logischen Schaltungen in Verbindung stehen, bei der der erste Feldeffekttransistor (14; 128; 162) mit seiner Source-Elektrode am Erdpotential und mit seiner Drain-Elektrode an einem ersten Ausgangsknotenpunkt (22; 126) angeschlossen ist, der über einen ersten Lastwiderstand mit einem beiden Feldeffekttransistoren gemeinsamen Drain-Potential verbunden ist, und bei der der zweite Feldeffekttransistor (18; 122; 160) mit seiner Source-Elektrode am Erdpotential und mit seiner Drain-Elektrode an einem zweiten Ausgangsknotenpunkt (24; 134) angeschlossen ist, der über einen zweiten Lastwiderstand mit dem Drain-Potential verbunden ist, dadurch gekennzeichnet, daß der erste Lastwiderstand eine als Widerstand ausgebildete Gate-Elektrode (20; 124) des zweiten Feldeffekttransistors und der zweite Lastwiderstand eine als Widerstand ausgebildete Gate-Elektrode (16; 132) des ersten Feldeffekttransistors ist.

2. Statische Speicherzelle nach Anspruch 1, dadurch gekennzeichnet, daß der erste Feldeffekttransistor (14) eine mit Erde verbundene Source-Zone (15) und eine mit dem ersten Ausgangsknoten (22) verbundene Drain-Zone (13) enthält, daß seine als Widerstand ausgebildete Gate-Elektrode (16) aus polykristallinem Silicium mit hohem Widerstandswert besteht und über dem Kanalbereich des ersten Feldeffekttransistors angeordnet ist, der die Source-Zone und die Drain-Zone des ersten Feldeffekttransistors voneinander trennt.

3. Statische Speicherzelle nach den Ansprüchen 1 und 2, dadurch gekennzeichnet, daß ein Ende der als Widerstand ausgebildeten Gate-Elektrode (16) des ersten Feldeffekttransistors über seiner Drain-Zone (13) liegt und mit dem Drain-Potential (VDD) verbunden ist und daß die Source-Zone (19) des zweiten Feld-effekttransistors (18) mit Erdpotential ver-bunden ist und die dazugehörige Drain-Zone (17) mit dem zweiten Ausgangsknoten (24).

4. Statische Speicherzelle nach den Ansprüchen 2 und 3, dadurch gekennzeichnet, daß die als Widerstand ausgebildete Gate-Elektrode (20) des zweiten Feldeffekttransistors mit einem Ende an den ersten Ausgangsknotenpunkt (22) und mit dem anderen Ende an das Drain-Potential (VDD) gelegt ist und von der darunterliegenden Drain-Zone (17) isoliert ist, und daß der Kanalbereich des zweiten Feldeffekttransistors (18) zwischen seiner Source-Zone (19) und seiner Drain-Zone (17) sowie unter seiner als Widerstand ausgebildeten Gate-Elektrode (20) liegt.

5. Statische Speicherzelle nach den Ansprüchen 1 bis 4, dadurch gekennzeichnet, daß die Schwellspannung (VTT) beider Feldeffekttransistoren ungefähr ein Drittel bis die Hälfte des Wertes des Drain-Potentials (VDD) ist.

6. Statische Speicherzelle nach den Ansprüchen 3 bis 5, dadurch gekennzeichnet, daß N-leitende Drain- und Source-Zonen (13, 15, 17 und 19) in ein aus Silicium bestehendes P-leitendes Substrat (27) eindiffundiert oder ionenimplantiert sind, daß die Oberfläche des Substrats (27) mit einer Siliciumdioxidschicht (23) bedeckt ist, auf der polykristallines Silicium für die als Widerstand ausgebildeten Gate-Elektroden (16 und 20) niedergeschlagen ist und daß jeweils ein Durchgangsloch (25) in der Siliciumdioxidschicht (23) die Gate-Elektrode (16) eines Feldeffekttransistors mit der Drain-Zone (17) des anderen Feldeffekttransistors verbindet und als jeweiliger Ausgangsknoten (22, 24) dient.

7. Statische Speicherzelle nach Anspruch 6, dadurch gekennzeichnet, daß die Siliciumdioxidschicht (23) jeweils einen dünnen Siliciumdioxidbereich (29) aufweist, der über dem jeweiligen Kanalbereich (31) angeordnet ist.

8. Statische Speicherzelle nach den Ansprüchen 1 bis 7, dadurch gekennzeichnet, daß die als Widerstand ausgebildeten Gate-Elektroden (16 und 20) aus einem zusammen-hängenden Stück polykristallinem Silicium ge-bildet sind, das selektiv dotiert ist, um die Leitfähigkeit zu erhöhen.

9. Statische Speicherzelle nach den Ansprüchen 1 bis 8, dadurch gekennzeichnet, daß die als Widerstand ausgebildeten Gate-Elektroden (16 und 20) der beiden eine Speicherzelle bildenden Feldeffekttransistoren (14 und 18) zur Erzeugung eines asymmetrischen Flip-Flops einen unterschiedlichen Widerstandswert aufweisen.

10. Verwendung einer statischen Speicherzelle nach den Ansprüchen 1 bis 8 in einem programmierfähigen logischen Schaltungsverband, dadurch gekennzeichnet, daß die Speicherzelle (14, 18) in dem Schaltungsverband als Programmierelement (58) für einen im UND-Bereich geschalteten Personalisierungstransistor (46) sowie als Programmierelement (70) für einen im ODER-Bereich geschalteten Personalisierungstransistor (56) verwendet wird.

**Claims**

1. Static storage cell consisting of two field effect transistors, the electrodes of which are interconnected and/or are connected to control, input and output lines in a storage cell array or in an arrangement of a multitude of controllable, logic circuits, wherein the first field effect transistor (14; 128; 162) is connected with its source electrode to ground potential and its drain electrode to a first output node (22; 126) which, via a first load resistor, is connected to a drain potential common to both field effect transistors, and wherein the second field effect transistor (18; 122; 160) is connected with its source electrode to ground potential and its drain electrode to a second output node (24; 134) which, via a second load resistor, is connected to the drain potential, characterised in that the first load resistor is a resistive gate electrode (20; 124) of the second field effect transistor and the second load resistor is a resistive gate electrode (16; 132) of the first field effect transistor.

2. Static storage cell as claimed in claim 1, characterised in that the first field effect transistor (14) comprises a source zone (15) connected to ground and a drain zone (13) connected to the first output node (22), and in that its resistive gate electrode (16) consists of polycrystalline silicon with a high resistivity and is disposed over the channel region of the first field effect transistor separating the source zone and the drain zone of the first field effect transistor from each other.

3. Static storage cell as claimed in claims 1 and 2, characterised in that one end of the resistive gate electrode (16) of the first field effect transistor lies over its drain zone (13) and is connected to the drain potential (VDD), and in that the source zone (19) of the second field effect transistor (18) is connected to ground potential and the drain zone (17) to the second output node (24).

4. Static storage cell as claimed in claims 2 and 3, characterised in that one end of the resistive gate electrode (20) of the second field effect transistor is connected to the first output node (22) and its other end to the drain potential (VDD), the electrode (20) being isolated from the drain zone (17) disposed thereunder, and in that the channel region of the second field effect transistor (18) is disposed between its source zone (19) and its drain zone (17) as well as underneath its resistive gate electrode (20).

5. Static storage cell as claimed in claims 1 to 4, characterised in that the threshold voltage (VTT) of both field effect transistors is about one third to one half of the magnitude of the drain potential (VDD).

6. Static storage cell as claimed in claims 3 to 5, characterised in that N conductive drain and source zones (13, 15, 17 and 19) are diffused or ion implanted into a P conductive substrate (27) consisting of silicon, that the surface of the substrate (27) is covered with a silicon dioxide layer (23) onto which the polycrystalline silicon for the resistive gate electrodes (16 and 20) is deposited, and in that a via hole (25) in the silicon dioxide layer (23) connects the gate electrode (16) of one field effect transistor to the drain zone (17) of the other field effect transistor and serves as the respective output node (22, 24).

7. Static storage cell as claimed in claim 6, characterised in that the silicon dioxide layer has one thin silicon dioxide region (29) respectively disposed over each channel region (31).

8. Static storage cell as claimed in any one of claims 1 to 7, characterised in that the resistive gate electrodes (16 and 20) are formed from a contiguous piece of polycrystalline silicon which is selectively doped to enhance the conductivity.

9. Static storage cell as claimed in any one of claims 1 to 8, characterised in that the resistive gate electrodes (16 and 20) of the two field effect transistors (14 and 18) forming a storage cell have different resistance values for producing an asymmetrical flip-flop.

10. A programmable logic circuit array comprising a multiplicity of static storage cells, each in accordance with any one of claims 1 to 8, characterised in that the storage cell (14, 18) in the circuit array is used as a programming element (58) for a personalization transistor (46) arranged in the AND region as well as a programming element (70) for a personalization transistor (56) arranged in the OR region.

**Revendications**

1. Cellule de mémoire statique composée de deux transistors à effet de champ dont les électrodes sont connectees entre elles et/ou à des lignes de sélection, d'entrée et de sortie d'un ensemble comportant une multitude de circuits logiques sélectables, dans laquelle le premier transistor à effet de champ (14; 128; 162) a sa source connectée au potentiel de terre et son drain à un premier noeud de sortie (22; 126) connecté, à son tour à travers une première résistance de charge, à un potentiel de drain commun aux deux transistors à effet de champ, et dans laquelle le second transistor à effet de champ (18; 122; 160) a sa source connectée au potentiel de terre et son drain à un deuxième noeud de sortie (24; 134) connecté, à son tour à travers une second résistance de charge, au potentiel de drain, caractérisée en ce que la première résistance de charge est une électrode de porte (20; 124), formant résistance, du second transistor à effet de champ et que la seconde résistance de charge est une électrode de porte (16; 132), formant résistance, du premier transistor à effet de champ.

2. Cellule de mémoire statique selon la revendication 1, caractérisée en ce que: le premier transistor à effet de champ (14) comporte une région de source (15) connectée à la terre et une région de drain (13) connectée au premier noeud de sortie (22), et en ce que son électrode de porte (16), formant résistance, est composée de silicium polycristallin ayant une valeur de résistance élevée et est placée sur la région de canal du premier transistor à effet de champ qui sépare ainsi les régions de source et de drain du premier transistor à effet de champ.

3. Cellule de mémoire statique selon les revendications 1 et 2, caractérisée en ce que: une extrémité de l'électrode de porte (16) formant résistance, du premier transistor à effet de champ est placée sur sa région de drain (13) et est connectée avec le potentiel de drain (VDD), et en ce que la région de source (19) du second transistor à effet de champ (18) est connectée au potentiel de terre et la région de drain correspondante (17) est connectée au second noeud de sortie (24).

4. Cellule de mémoire statique selon les revendications 2 et 3, caractérisée en ce que: l'électrode de porte (20), formant résistance, du second transistor à effet de champ a une de ses extrémités connectée au premier noeud de sortie (22) et son autre extrémité au potentiel de drain (VDD), et est isolée de la région de drain sous-jacente (17), et en ce que la région de canal du second transistor à effet de champ (18) est placée entre sa région de source (19) et sa région de drain (17) et sous son électrode de porte (20) formant résistance.

5. Cellule de mémoire statique selon les revendications 1 à 4, caractérisée en ce que: la tension de seuil (VTT) des deux transistors à effet de champ est d'environ un tiers à la moitié de la valeur du potentiel de drain (VDD).

6. Cellule de mémoire statique selon les revendications 3 à 5, caractérisée en ce que: les régions de drain et de source du type N (13, 15, 17 et 19) sont introduites dans un substrat (27) composé de silicium du type P par diffusion ou implantation ionique, en ce que la surface du substrat (27) est recouverte d'une couche de dicxyde de silicium (23) sur laquelle a été déposé du silicium polycristallin pour les électrodes de porte (16 et 20) formant résistance, et en ce que un trou de traversée (25) dans la couche de dioxyde de silicium (23) connecte l'électrode de porte (16) d'un transistor à effet de champ avec la région de drain (17) de l'autre transistor à effet de champ et sert de noeud de sortie (22, 24).

7. Cellule de mémoire statique selon la revendication 6, caractérisée en ce que: la couche de dioxyde de silicium (23) est recouverte d'une région de dioxyde de silicium mince (29) qui est disposée sur la région de canal (31), respective.

8. Cellule de mémoire statique selon les revendications 1 à 7, caractérisée en ce que: les électrodes de porte (16 et 20), formant résistances, sont composées chacune d'une pièce continue de silicium polycristallin sélectivement dopée pour augmenter la conductivité.

9. Cellule de mémoire statique selon les revendications 1 à 8, caractérisée en ce que: les électrodes de porte (16 et 20) formant résistance des deux transistors à effet de champ (14 et 18) constituant une cellule de mémoire présentent une valeur de résistance différente pour obtenir une bascule asymétrique.

10. Utilisation d'une mémoire de cellule statique selon les revendications 1 à 8, dans un ensemble de circuits logiques programmable, caractérisée en ce que: la cellule de mémoire (14, 18) dans l'ensemble de circuits est utilisée comme élément de programmation (58) pour un transistor personnalisé (46) permettant de réaliser un circuit logique ET et comme élément de programmation (70) pour un transistor personnalisé (56) permettant de réaliser un circuit logique OU.

FIG. 1

FIG. 2

FIG. 3a

SCHNITT A—A'

FIG. 3b

SCHNITT B—B'

FIG. 3c

FIG. 4a

FIG. 4b

FIG. 4c

**0 002 486**

FIG. 5a

SCHNITT A-A'

FIG. 5b

SCHNITT B-B'

FIG. 5c

3

0 002 486

FIG. 6

FIG. 7

FIG. 8